# EUROPÄISCHE PATENTSCHRIFT

(11) **EP 1 883 826 B1**
(45) Veröffentlichungstag und Bekanntmachung des Hinweises auf die Patenterteilung: **14.05.2014**
(21) Anmeldenummer: 06723633.1
(22) Anmeldetag: 22.03.2006
(51) Int. Cl.: G01R 1/067

(54) **TAST- ODER MESSKOPF MIT BELEUCHTUNG DES KONTAKTBEREICHS**
PROBE OR MEASURING HEAD WITH ILLUMINATION OF THE CONTACT REGION
SONDE OU TETE DE MESURE DOTEE D'UN ECLAIRAGE DE LA ZONE DE CONTACT

(30) Priorität: 20.05.2005 DE 102005023425
(43) Veröffentlichungstag der Anmeldung: 06.02.2008
(73) Patentinhaber: Rohde & Schwarz GmbH & Co. KG, 81671 München (DE)
(72) Erfinder: BOSS, Hermann, 83607 Holzkirchen (DE); STEFFENS, Johannes, 83026 Rosenheim (DE)
(74) Vertreter: Körfer, Thomas
(86) Internationale Anmeldenummer: PCT/EP2006/002641
(87) Internationale Veröffentlichungsnummer: WO 2006/122600

(56) Entgegenhaltungen:
- EP-A- 0 974 844
- EP-A- 1 203 962
- US-A- 4 126 380
- PATENT ABSTRACTS OF JAPAN Bd. 017, Nr. 619 (P-1644), 15. November 1993 (1993-11-15) & JP 05 196637 A (NEC NIIGATA LTD), 6. August 1993 (1993-08-06)
- PATENT ABSTRACTS OF JAPAN Bd. 1997, Nr. 05, 30. Mai 1997 (1997-05-30) & JP 09 026435 A (HITACHI DENSHI LTD), 28. Januar 1997 (1997-01-28)

## Beschreibung

Die Erfindung betrifft einen Tast- oder Meßkopf mit Beleuchtung des Kontaktbereichs des Tast- oder Meßkopfs und des umgebenden Meßumfelds.

Tast- oder Meßköpfe sind wichtig bei der elektrischen Messung von analogen oder digitalen Schaltungen. In der EP 0 570 840 B1 ist beispielsweise ein derartiger Tast- oder Meßkopf beschrieben und dargestellt. Im wesentlichen bestehen solche Tast- oder Meßköpfe aus einem elektrisch leitenden Taststift, welcher in einem nichtleitenden Gehäuse axial geführt ist, das zur bequemen manuellen Handhabung des Tast- oder Meßkopfs als Griff ausgeformt ist. Das im Gehäuse befindliche Ende des elektrisch leitenden Taststiftes ist über eine Verbindungsleitung mit einem Meßkanal des Meßgerätes bzw.- Systems verbunden, während das aus dem Gehäuse herausragende Ende des elektrisch leitenden Stiftes einen Kontaktbereich-bevorzugt eine Spitze - aufweist, der bei der Messung mit dem zu vermessenden elektrischen Kontakt in Berührung steht. Solche Tastköpfe werden als aktive oder passive Tastköpfe bei Oszilloskopen, aber auch bei Spektrumanalysatoren und Netzwerkanalysatoren eingesetzt.

Die zwischenzeitlich handelsüblich erhältlichen Tast- oder Meßköpfe weisen eine Vielzahl von mechanischen Funktionsmerkmalen auf, die eine sichere und komfortable Kontaktierung des Tast- oder Meßkopfs mit dem zu vermessenden elektrischen Kontakt auch bei klein dimensionierten Schaltungsstrukturen ermöglichen. Trotz technisch ausgereifter Tast- oder Meßköpfe bleibt die Kontaktierung aber bei zunehmender Miniaturisierung der Schaltungsstrukturen, bei schlecht zugänglichen Schaltungselementen und bei schlechten Lichtverhältnissen problematisch.

EP 0 974 844 A1 zeigt einen Tast- oder Messkopf, der eine Lichtquelle aufweist, um die Messspitze bzw. das Messumfeld zu beleuchten.

EP 1 203 962 A2 beschreibt ein Messgerät mit zwei Messkanälen, wobei an einem Messkanal eine Kamera angeschlossen ist und wobei auf der Kamera eine Lichtquelle angebracht ist.

US 4,126,380 zeigt ein Rohrsystem, mit dessen Hilfe das Licht von einer Messspitze um Ecken zu dem Betrachter geleitet wird. An ein weiteres separates Rohr kann eine Lichtquelle, die nicht Bestandteil des Messkopfes ist, gehalten werden, sodass der Kontaktbereich beleuchtet wird.

Patent Abstract Japan 05196637 zeigt einen Messkopf, der über eine Lichtquelle verfügt.

Patent Abstract Japan 09026435 zeigt eine Messspitze mit einer Kamera.

US 6,377,054 B1 zeigt ein kleines Anzeigegerät für Spannungen in Form eines Kugelschreibers. Das Gerät beinhattet eine einfache Lampe, die anzeigt, ob eine Spannung an einem Leiter anliegt, wenn das Gerät mit diesem Leiter verbunden ist.

US 5,672,964 zeigt einen Messkopf mit einer Beleuchtung.

Der Erfindung legte deshalb die Aufgabe zugrunde, einen Tast- oder Meßkopf derart weiterzuentwickeln, daß bei hoher Miniaturisierung der Schaltungsstrukturen, schlecht zugänglichen Schaltungselementen und schlechten Lichtverhältnissen eine sichere und komfortable Kontaktaufnahme zwischen dem zu vermessenden elektrischen Kontakt und der Tastspitze des Tast- oder Meßkopfes gewährleistet ist.

Die Aufgabe der Erfindung wird durch einen Tast- oder Meßkopf mit den Merkmalen des Anspruchs 1 gelöst. Vorteilhafte Weiterbildungen der Erfindung sind in den Ansprüchen 2 bis 8 aufgeführt.

Im Hinblick auf bessere Sichtverhältnisse im Bereich der Tast- bzw. Meßspitze des Tast- oder Meßkopfes und des zu vermessenden elektrischen Kontaktes bei schlechten Lichtverhältnissen bzw. bei schlecht zugänglichen Bauteilen wird eine Beleuchtung der Tast- bzw. Meßspitze des Tast- oder Meßkopfes und des umgebenden Meßumfeldes vorgesehen. Hierbei handelt es sich um eine Lichtquelle, die entweder in der Nähe der Meß-Tastspitze oder innerhalb des Meß- oder Tastkopfes oder in einem mit dem Meß- oder Tastkopf verbundenen Meßgerät oder -system oder in einem mit dem Meß- oder Tastkopf verbundenen zusätzlichen Modul plaziert ist.

Ist die Lichtquelle innerhalb des Meß- oder Tastkopfs, in einem mit dem Meß- oder Tastkopf verbundenen Meßgerät oder -system oder in einem mit dem Meß- oder Tastkopf verbundenen zusätzlichen Modul integriert, so werden die Lichtstrahlen einer derart plazierten Lichtquelle über Lichtwellenleiter, bevorzugt Kunststoff-Lichtwellenleiter, zur Meß- oder Tastspitze des Meß- oder Tastkopfes geführt. Im Fall der Plazierung der Lichtquelle im Gehäuse des Meß- oder Tastkopfes kann hierfür die den elektrischen leitenden Taststift bis zur Meß- oder Tastspitze ummantelnde Isolierschicht verwendet werden.

Anstelle der Verwendung der Isolierschicht als Lichtwellenleiter können im Falle einer Plazierung der Lichtquelle im Gehäuse des Meß- oder Tastkopfes die Lichtstrahlen der Lichtquelle über Ausnehmungen im Gehäuse des Meß- oder Tastkopfes zur Meß- oder Tastspitze des Meß- oder Tastkopfes geführt werden.

Eine gezielte Bündelung der Lichtstrahlen im Hinblick auf eine hohe Lichtintensität im Bereich der Meß- oder Tastspitze wird durch gezielte Ausformung der Isolierschicht bzw. der Ausnehmungen im Gehäuse des Meß- oder Tastkopfes sowie durch geeignete Plazierung der Ausnehmungen im Gehäuse des Meß- oder Tastkopfes erreicht.

Sind dagegen diffuse Lichtverhältnisse im Bereich der Meß- oder Tastspitze erwünscht, so wird eine lichtstreuende Schicht an dem der Meß- oder Tastspitze zugewandten Ende der Isolierschicht oder innerhalb der Ausnehmungen im Gehäuse des Meß- oder Tastkopfes angebracht.

Durch Verwendung mehrerer verschieden farbig leuchtender Leuchtdioden als Lichtquelle und einer geeigneten Ansteuerung der Leuchtdioden kann mit der Farbe der Lichtstrahlen der vom Meß- oder Tastkopf benutzte Meßkanal des Meßgerätes oder -systems gekennzeichnet werden. Alternativ kann mit der Farbe der Lichtstrahlen die vom Meß- oder Tastkopf gemessene Höhe des elektrischen Potentials des elektrischen Kontaktes wiedergegeben werden.

Schließlich kann durch Vorsehen einer optischen Linse, welche am Meß- oder Tastkopf justierbar geführt wird, eine Vergrößerung der Meß- oder Tastspitze und das mit der Meß- oder Tastspitze zu messende Meßumfelds verwirklicht werden. Analog kann auch eine miniaturisierte Kamera beispielsweise in Mikrosystemtechnik den Vorgang der Kontaktbildung der Meß- oder Tastspitze mit dem elektrischen Kontakt aufnehmen und über eine nachfolgende Bildverarbeitung auftretende Fehler einer automatisierten Messung mehrerer elektrischer Kontakte identifizieren.

Die bevorzugten Ausführungsbeispiele des erfindungsgemäßen Meß- oder Tastkopfes mit Beleuchtung des Kontaktbereichs des Meß- oder Tastkopfes werden im folgenden unter Bezugnahme auf die Zeichnung erläutert. In der Zeichnung zeigen:
- Fig. 1: eine Querschnittsdarstellung einer ersten Ausführungsform des erfindungsgemäßen Meß- oder Tastkopfes mit Beleuchtung des Kontaktbereichs des Meß- oder Tastkopfes und des umgebenden Meßumfeldes,
- Fig. 2: eine Querschnittsdarstellung einer zweiten Ausführungsforrm des erfindungsgemäßen Meß- oder Tastkopfes mit Beleuchtung des Kontaktbereichs des Meß- oder Tastkopfes und des umgebenden Meßumfeldes,
- Fig. 3: eine Querschnittsdarstellung einer dritten Ausführungsform des erfindungsgemäßen Meß- oder Tastkopfes mit Beleuchtung des Kontaktbereichs des Meß- oder Tastkopfes und des umgebenden Meßumfeldes,
- Fig. 4: eine Querschnittsdarstellung einer vierten Ausführungsform des erfindungsgemäßen Meß- oder Tastkopfes mit Beleuchtung des Kontaktbereichs des Meß- oder Tastkopfes und des umgebenden Meßumfeldes,
- Fig. 5: eine Querschnittsdarstellung einer fünften Ausführungsform des erfindungsgemäßen Meß- oder Tastkopfes mit Beleuchtung des Kontaktbereichs des Meß- oder Tastkopfes und des umgebenden Meßumfeldes,
- Fig. 6: eine Querschnittsdarstellung einer sechsten Ausführungsforrm des erfindungsgemäßen Meß- oder Tastkopfes mit Beleuchtung des Kontaktbereichs des Meß- oder Tastkopfes und des umgebenden Meßumfeldes und
- Fig. 7: eine Querschnittdarstellung einer siebten Ausführungsforrm des erfindungsgemäßen Meß- oder Tastkopfes mit Beleuchtung des Kontaktbereichs des Meß- oder Tastkopfes und des umgebenden Meßumfeldes.

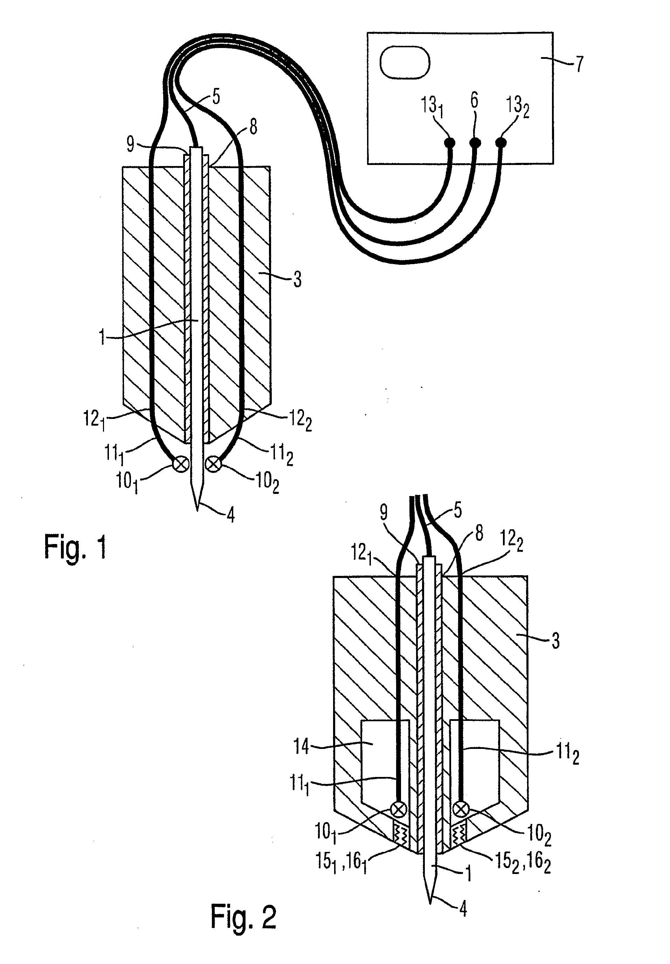

Im folgenden werden anhand der Figuren 1 bis 7 die bevorzugten Ausführungsformen des erfindungsgemäßen Meß- oder Tastkopfes mit Beleuchtung des Kontaktbereich des Meß- oder Tastkopfes und des umgebenden Meßumfeldes dargestellt, wobei sich die Darstellungen auf schematische Darstellungen der erfindungswesentlichen Merkmale beschränken.

Die erste Ausführungsform des erfindungsgemäßen Meß- oder Tastkopfes in Fig. 1 besteht aus einem elektrischen leitenden Taststift 1, der in einer zentralen Innenbohrung 2 eines im wesentlichen zylindrischen Gehäuses 3 axial geführt ist.

Der Taststift 1 ist teilweise aus dem Gehäuse 3 herausgeführt und weist an dem Ende, das aus dem Gehäuse 3 herausgeführt ist, einen Kontaktbereich 4 auf, mit dem der Meß- oder Tastkopf mit dem zu vermessenden elektrischen Kontakt der elektrischen Schaltung in Berührung kommt. Der Kontaktbereich 4 ist bevorzugt als Meß- oder Tastspitze ausgeführt, um auch miniaturisierte elektrische Schaltungen mit elektrischen Kontakten geringer geometrischer Ausdehnung sicher und korrekt vermessen zu können. Anstelle einer Meß- oder Tastspitze kann der Kontaktbereich 4 des Stiftes 1 entsprechend dem jeweils vorliegenden Anwendungsproblem aber auch anderweitig ausgeformt sein. Das andere Ende der Stiftes 1 ist über eine Verbindungsleitung 5 mit einem Meßkanal 6 eines Meßgeräts oder -systems 7 verbunden.

Im Hinblick auf eine ergonomisch optimierte Handhabung des erfindungsgemäßen Meß- oder Tastkopfes wird das Gehäuse 3 in Form eines im wesentlichen zylindrischen Griffes ausgeformt. Aus Isolationsgründen wird der in der zentralen Innenbohrung 8 des Gehäuses 3 axial geführte Taststift 1 von einer hülsenförmigen Isolierschicht 9, die bevorzugt aus einem Kunststoffmaterial hergestellt ist, ummantelt. Um dem Anwender des Meß- oder Tastkopfes eine freie Sicht auf den Kontaktbereich 4 des Taststiftes 1 und das den Kontaktbereich 4 umgebende Meßumfeld zu ermöglichen, ist das im wesentlichen zylindrisch geformte Gehäuse 3 an seinem dem Kontaktbereich 4 des Taststiftes 1 zugewandten Ende konisch ausgeführt.

Die erfindungsgemäße Beleuchtung des Kontaktbereichs 4 des Taststiftes 1 - beispielsweise der Meß- oder Tastspitze 4 des Taststiftes 1 - erfolgt je nach erforderlicher Lichtintensität und Ausleuchtung der Meß- oder Tastspitze 4 und des umgebenden Meßumfeldes über eine oder mehrere Lichtquellen 10₁,₁₀₂,..., 10ₙ - beispielsweise Leuchtdioden -, die am Taststift 1 in Fig. 1 dargestellten Ausführungsbeispiel außerhalb des Gehäuses 3 befestigt sind. Die Verwendung mehrerer Lichtquellen 10₁, 10₂,...,10ₙ ermöglicht die Gestaltung einer mehrfarbigen Beleuchtung. Die Mehrfarbigkeit der Beleuchtung ermöglicht beispielweise die Anzeige des vom Meß- oder Tastkopf 1 verwendeten Meßkanals 6 des Meßgeräts oder -Systems 7 oder der Höhe des vom Meß- oder Tastkopf 1 am elektrischen Kontakt gemessenen elektrischen Potentials, falls eine Zuordnung zwischen der Höhe des gemessenen elektrischen Potentials und dem Farbton der Beleuchtung besteht.

Die in Fig. 1 dargestellten zwei Lichtquellen 10₁ und 10₂ sind über jeweils eine zugehörige Verbindungsleitung 11₁ und 11₂, welche über jeweils einen Leitungskanal 12₁ und 12₂ im Gehäuse 3 und anschließend im Leitungsverbund mit der Verbindungsleitung 5 geführt werden, mit Stromversorgungsanschlüssen 13₁ und 13₂, im Meßgerät bzw. - System 7 verbunden.

In Fig. 2 ist eine zweite Ausführungsform des erfindungsgemäßen Meß- oder Tastkopfes dargestellt. Identischen Merkmalen der zweiten Ausführungsform wie auch der folgenden Ausführungsformen zur ersten Ausführungsform des erfindungsgemäßen Meß- oder Tastkopfes in Fig. 1 sind identische Bezugszeichen zugewiesen und auf eine wiederholte Beschreibung dieser identischen Merkmale wird im folgenden verzichtet.

In der zweiten Ausführungsform des erfindungsgemäßen Meß- oder Tastkopfes werden die einzelnen Lichtquellen 10₁, 10₂,..., 10ₙ nicht außerhalb des Gehäuses 3, sondern in einer Ausnehmung 14 des Gehäuses 3 positioniert. Die Lichtführung der von den einzelnen Lichtquellen 10₁, 10₂,..., 10ₙ erzeugten Lichtstrahlen von der Ausnehmung 14 des Gehäuses 3 zum Kontaktbereich 3 des Taststiftes 1 erfolgt über jeweils den einzelnen Lichtquellen 10₁, 10₂, ... , 10ₙ zugeordnete Ausnehmungen 15₁, 15₂, ... , 15ₙ oder eine allen einzelnen Lichtquellen 10₁, 10₂, .. ,10ₙ gemeinsam zugeordnete Ausnehmung 15, die jeweils von der Ausnehmung 14 in Richtung des Kontaktbereichs 4 des Taststifts 1 geführt sind. Eine ausreichende Beleuchtung des Kontaktbereich 4 des Taststiftes 1 und des den Kontaktbereich 4 umgebenden Meßumfeldes ist bei der zweiten Ausführungsform nur dann gewährleistet, wenn der Abstand des Kontaktbereichs 4 des Taststiftes 1 zum Gehäuse 3 des erfindungsgemäßen Meß- oder Tastkopfes und der Abstand der in der Ausnehmung 14 angeordneten einzelnen Lichtquellen 10₁,10₂,...,10ₙ zum Austritt der Lichtstrahlen aus dem Gehäuse 3 des erfindungsgemäßen Meß- oder Tastkopfes minimiert ist.

Zur zielgerichteten Bündelung der Lichtstrahlen der einzelnen Lichtquellen 10₁, 10₂,..., 10ₙ zur Erhöhung der Lichtintensität und besseren Ausleuchtung des Kontaktbereichs 4 des Taststiftes 1 und des umgebenden Meßumfeldes erfolgt eine geeignete Ausformung und Positionierung der einzelnen Ausnehmungen 15₁, 15₂,...,15ₙ im Gehäuse 3 des erfindungsgemäßen Meß- oder Tastkopfs. Wird dagegen eine diffuse Beleuchtung im Kontaktbereich 4 des Taststiftes 1 und im umgebenden Meßumfeld angestrebt, so werden die Ausnehmungen 15₁,15₂,..., 5ₙ mit einer lichtstreuenden Schicht ausgefüllt.

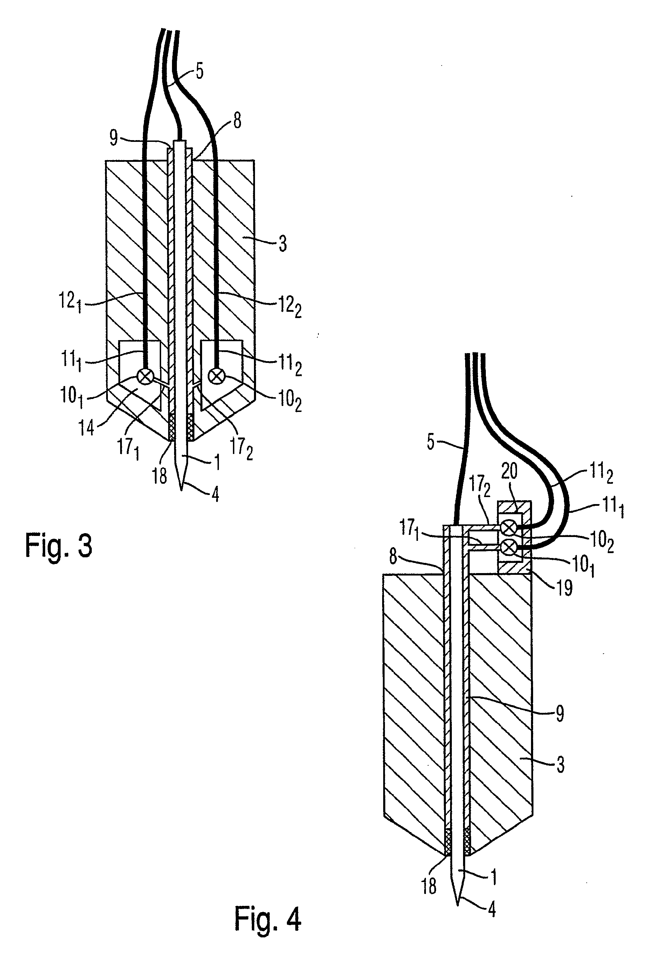

Bei der in Fig. 3 gezeigten dritten Ausführungsform des erfindungsgemäßen Meß- oder Tastkopfes werden die einzelnen Lichtquellen 10₁, 10₂,..., 10ₙ ebenfalls in der Ausnehmung 14 des Gehäuses 3 positioniert. Die Lichtführung erfolgt aber bei dieser dritten Ausführungsform nicht über die Ausnehmungen 15₁, 15₂,...,15ₙ und 15ₘ im Gehäuse 3, sondern über die hülsenförmige Isolierschicht 9, die aus einem lichtleitenden Kunststoffmaterial besteht. Die Zuführung der von den Lichtquellen 10₁,10₂,...,10ₙ erzeugten Lichtstrahlen zur hülsenförmigen Isolierschicht 9, die den axial geführten Taststift 1 ummantelt, erfolgt jeweils über ebenfalls aus lichtleitendem Kunststoffmaterial bestehende Lichtleiter 17₁, 17₂, ... ,17ₙ.

Auch bei der dritten Ausführungsform kann eine gezielte Bündelung der Lichtstrahlen der einzelnen Lichtquellen 10₁, 10₂,..., 10ₙ durch geeignete Ausformung des Querschnitts der Isolierschicht 9 verwirklicht werden. Eine diffuse Beleuchtung im Kontaktbereich 4 des Taststiftes 1 und im umgebenden Meßumfeld wird durch Anbringung einer lichtstreuenden Schicht 18 am Austritt der Isolierschicht 9 aus der Innenbohrung 8 des Gehäuses 3 in der Nähe des Kontaktbereiches 4 des Taststiftes 1 erzielt.

Die vierte Ausführungsform des erfindungsgemäßen Meß- oder Tastkopfes in Fig. 4 platziert die einzelnen Lichtquellen 10₁,10₂,...,10ₙ in einer Ausnehmung 20 eines zusätzlichen Moduls 19, das mit dem Gehäuse 3 des erfindungsgemäßen Meß- oder Tastkopfes verbunden ist. Die Lichtführung der Lichtstrahlen der einzelnen Lichtquellen 10₁, 10₂,...,10ₙ erfolgt in Analogie zur dritten Ausführungsform in Fig. 3 über die lichtleitende Isolierschicht 9. Die Zuführung der von den Lichtquellen 10₁, 10₂,...,10ₙ erzeugten Lichtstrahlen zur Isolierschicht 9 wird ebenfalls wie in der dritten Ausführungsform über ebenfalls aus lichtleitenden Kunststoffmaterial bestehende Lichtleiter 17₁,17₂,...,17ₙ realisiert. Die Bündelung der Lichtstrahlen erfolgt in Analogie zur dritten Ausführungsform durch eine geeignete Ausformung der Isolierschicht 9. Eine diffuse Beleuchtung wird durch Anbringung einer lichtstreuenden Schicht 18 am Austritt der Isolierschicht 9 aus der Innenbohrung 8 des Gehäuses 3 in der Nähe des Kontaktbereichs des Taststiftes 1 erzielt.

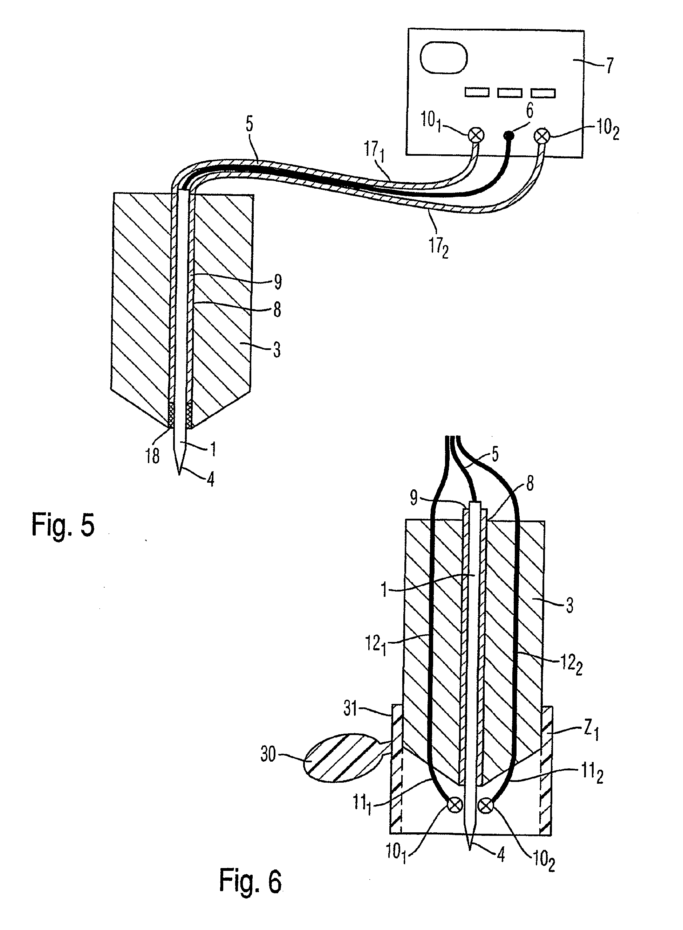

In der fünften Ausführungsform des erfindungsgemäßen Meß- oder Tastkopfes in Fig. 5 sind die einzelnen Lichtquellen 10₁, 10₂,...,10ₙ im Meßgerät bzw. -system 7 plaziert, deren Lichtstrahlen jeweils über die Lichtleiter 17₁, 17₂,...,17ₙ im Leitungsverbund mit der Verbindungsleitung 5 zur lichtleitenden Isolierschicht 9 geführt sind. Der geometrische Aufbau des erfindungsgemäßen Meß- oder Tastkopfes der fünften Ausführungsform sowie die Lichtführung, Lichtbündelung oder Lichtstreuung entspricht der vierten Ausführungsform des erfindungsgemäßen Meß- oder Tastkopfes in Fig. 4.

In der sechsten Ausführungsform des erfindungsgemäßen Meß oder Tastkopfes in Fig. 6 wird zur Vergrößerung des Kontaktbereichs 4 des Taststiftes 1 und des umgebenden Meßumfeldes eine optische Linse 30, in Fig. 6 beispielsweise an einer Hülse 31 angeformt - entlang des Taststiftes 1 justierbar geführt. Die Ausführung der Beleuchtung der sechsten Ausführungsform des erfindungsgemäßen Meß- oder Tastkopfes in Fig. 6 entspricht der ersten Ausführungsform des erfindungsgemäßen Meß- oder Tastkopfes in Fig. 1. Alternativ können aber auch die in den Figuren 2 bis 5 dargestellten Ausführungen der Beleuchtung gewählt werden.

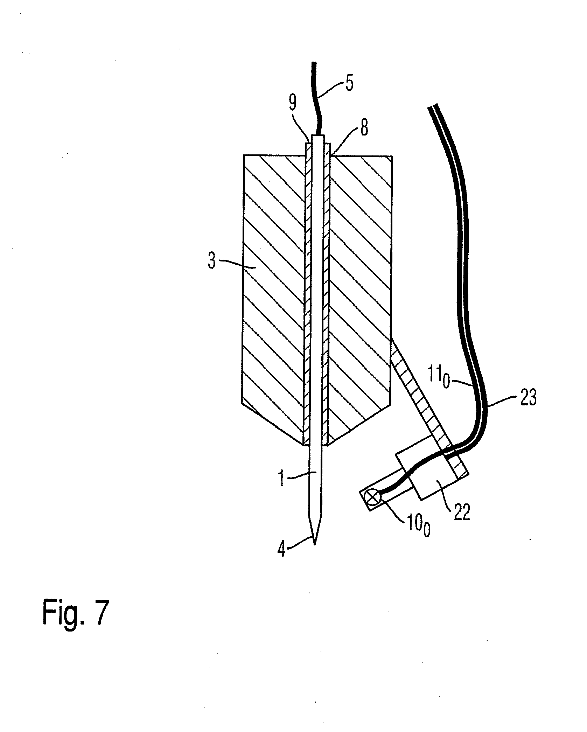

Schließlich ist in Fig. 7 eine siebte Ausführungsform des erfindungsgemäßen Meß- oder Tastkopfes dargestellt, bei der der Kontaktbereich 4 des Taststiftes 1 und das den Kontaktbereich 4 umgebende Meßumfeld von einer Kamera 22 eingefangen wird. Die Kamera 22 ist beispielsweise in Mikrosystemtechnik miniaturisiert und mit dem Gehäuse 3 des erfindungsgemäßen Meß- oder Tastkopfes mechanisch verbunden. Die von der Kamera 22 aufgenommenen Videodaten werden über eine Verbindungsleitung 23 zum Meßgerät bzw. - system 7 zur weiteren Verarbeitung übertragen. Die Beleuchtung des Kontaktbereichs 4 des Taststiftes 1 und des den Kontaktbereich 4 umgebenden Meßumfeldes kann durch eine auf der Kamera 22 befestigte Lichtquelle 10ₒ realisiert werden. Alternativ kann der Kontaktbereich 4 des Stiftes 1 und das den Kontaktbereich 4 umgebende Meßumfeld durch eine Beleuchtungsausführung entsprechend der ersten bis fünften Ausführungsform des erfindungsgemäßen Meß- oder Tastkopfes in den Figuren 1 bis 5 ausgeleuchtet werden.

Die Erfindung ist nicht auf die dargestellten Ausführungsformen beschränkt. Insbesondere sind von der Erfindung auch andere Plazierungen der Lichtquellen und andere Ausprägungen der Lichtführung, der Lichtbündelung und der Lichtstreuung, welche in den vorgestellten Ausführungsformen nicht dargestellt sind, abgedeckt.

## Patentansprüche

1. Tast- oder Messkopf zur Messung eines elektrischen Signals eines elektrischen Kontakts mit einem aus einem Gehäuse (3) hervorragenden elektrisch leitenden Taststift (1), an dessen Ende ein mit dem elektrischen Kontakt in Berührung bringbarer Kontaktbereich (4) vorgesehen ist, wobei der Kontaktbereich (4) des Taststiftes (1) und das den Kontaktbereich (4) des Stiftes (1) umgebende Messumfeld von einer mit dem Tast- oder Messkopf in Verbindung stehenden Lichtquelle (10₁, 10₂,...,10ₙ,10ₒ) beleuchtet ist,
**dadurch gekennzeichnet,**
**dass** die Farbe der von der Lichtquelle erzeugten Lichtstrahlen den vom Tast- oder Messkopf am Messgerät (7) benutzten Messkanal (6) kennzeichnet.

2. Tast- oder Messkopf nach Anspruch 1,
**dadurch gekennzeichnet,**
**dass** die Beleuchtung des Kontaktbereichs (4) und des den Kontaktbereich (4) des Taststiftes (1) umgebenden Messfeldes durch die Lichtstrahlen einer am Taststift (1) in der Nähe des Kontaktbereichs (4) angeordneten Lichtquelle (10₁, 10₂,...,10ₙ) erfolgt.

3. Tast- oder Messkopf nach Anspruch 1,
**dadurch gekennzeichnet,**
**dass** die Beleuchtung des Kontaktbereichs (4) des Taststiftes (1) und des den Kontaktbereich (4) des Taststiftes (1) umgebenden Messumfeldes durch die Lichtstrahlen einer Lichtquelle (10₁, 10₂,...,10ₙ) erfolgt, die sich im Gehäuse (3) des Tast- oder Messkopfes, in einem mit dem Tast- oder Messkopf verbundenen Messgerät (7) oder in einem anderen mit dem Tast- oder Messkopf in Verbindung stehenden Modul (19) befindet.

4. Tast- oder Messkopf nach Anspruch 3,
**dadurch gekennzeichnet,**
**dass** die Lichtstrahlen der Lichtquelle (10₁, 10₂,...,10ₙ), die sich im Gehäuse (3) des Tast- oder Messkopfes, im mit dem Tast- oder Messkopf verbundenen Messgerät (7) oder in einem mit dem Tast- oder Messkopf in Verbindung stehenden zusätzlichen Modul (19) befindet, über eine den Taststift (1) mit Ausnahme des Kontaktbereiches (4) ummantelnde Isolierschicht (9) zum Kontaktbereich (4) des Taststiftes (1) und zu dem den Kontaktbereich (4) des Taststiftes (1) umgebenden Messumfeld geführt sind.

5. Tast- oder Messkopf nach Anspruch 3,
**dadurch gekennzeichnet,**
**dass** die Lichtstrahlen der Lichtquelle (10₁, 10₂,...,10ₙ), die sich im Gehäuse (3) des Tast- oder Messkopfes, im mit dem Tast- oder Messkopf verbundenen Messgerät (7) oder in einem mit dem Tast- oder Messkopf in Verbindung stehenden zusätzlichen Modul (19) befindet, durch mindestens eine Ausnehmung (15₁, 15₂,..., 15ₙ, 15ₘ) im Gehäuse (3) zum Kontaktbereich (4) des Taststiftes (1) und zu dem den Kontaktbereich (4) des Taststiftes (1) umgebenden Messumfeld geführt sind.

6. Tast- oder Messkopf nach Anspruch 4 oder 5,
**dadurch gekennzeichnet,**
**dass** eine Bündelung der Lichtstrahlen durch eine gezielte Ausformung der Isolierschicht (9) und durch eine gezielte Ausformung und Platzierung der Ausnehmungen (15₁, 15₂,..., 15ₙ, 15ₘ) im Gehäuse (3) erfolgt.

7. Tast- oder Messkopf nach einem der Ansprüche 4 bis 6,
**dadurch gekennzeichnet,**
**dass** zur Erzielung eines diffusen Lichtstrahls an dem dem Kontaktbereich (4) zugewandten Ende der Isolierschicht (9) und/oder in den Ausnehmungen (15₁, 15₂,..., 15ₙ, 15ₘ) im Gehäuses (3) eine lichtstreuende Schicht (18) angebracht ist.

8. Tast- oder Messkopf nach einem der Ansprüche 1 bis 7, **dadurch gekennzeichnet,**
**dass** zur Vergrößerung der Kontaktbereichs (4) des Taststiftes (1) und des den Kontaktbereich (4) des Taststiftes (1) umgebenden Messfeldes eine optische Linse (21) oder Kamera (22) entlang des Stiftes (1) justierbar geführt ist.

## Claims

1. A probe or measuring head for measuring an electrical signal of an electrical contact comprising an electrically conductive probe pin (1) projecting from a housing (3), at the end of which a contact region (4) which can be brought into contact with the electrical contact is provided,
wherein the contact region (4) of the probe pin (1) and the test environment surrounding the contact region (4) of the pin (1) is illuminated by a light source (10₁, 10₂, ..., 10ₙ, 10₀) connected to the probe or measuring head,
**characterised in that**
the colour of the light rays generated by the light source indicates the measurement channel (6) used by the probe or measuring head in the measuring instrument (7).

2. The probe or measuring head according to claim 1,
**characterised in that**
the illumination of the contact region (4) and of the the test environment surrounding the contact region (4) of the probe pin (1) is implemented by the light rays of a light source (10₁, 10₂, ..., 10ₙ) disposed on the probe pin (1) in the proximity of the contact region (4).

3. The probe or measuring head according to claim 1,
**characterised in that**
the illumination of the contact region (4) of the probe pin (1) and of the test environment surrounding the contact region (4) of the probe pin (1) is implemented by the light rays of a light source (10₁, 10₂, ..., 10ₙ) which is disposed in the housing (3) of the probe or measuring head in a measuring instrument (7) connected to the probe or measuring head or in another module (19) connected to the probe or measuring head.

4. The probe or measuring head according to claim 3,
**characterised in that**
the light rays of the light source (10₁, 10₂, ..., 10ₙ) which is disposed in the housing (3) of the probe or measuring head within the measuring instrument (7) connected to the probe or measuring head or within an additional module (19) connected to the probe or measuring head are guided towards the contact region (4) of the probe pin (1) and towards the test environment surrounding the contact region (4) of the probe pin (1) via an insulating layer (9) which encases the probe pin (1) with the exception of the contact region (4).

5. The probe or measuring head according to claim 3,
**characterised in that**
the light rays from the light source (10₁, 10₂, ..., 10ₙ) which is disposed in the housing (3) of the probe or measuring head within the measuring instrument (7) connected to the probe or measuring head or within an additional module (19) connected to the probe or measuring head are guided towards the contact region (4) of the probe pin (1) and towards the measuring environment surrounding the contact region (4) of the probe pin (1) through at least one recess (15₁, 15₂, ..., 15ₙ, 15ₘ) in the housing (3).

6. The probe or measuring head according to claim 4 or 5,
**characterised in that**
a bundling of the light rays is implemented through a targeted formation of the insulating layer (9) and through a targeted formation and positioning of the recesses (15₁, 15₂, ..., 15ₙ, 15ₘ) in the housing (3).

7. The probe or measuring head according to any one of claims 4 to 6,
**characterised in that**
a light-scattering layer (18) is provided in order to achieve a diffuse light beam at the end of the insulating layer (9) facing towards the contact region (4) and/or in the recesses (15₁, 15₂, ..., 15ₙ, 15ₘ) in the housing (3).

8. The probe or measuring head according to any one of claims 1 to 7,
**characterised in that**
an optical lens (21) or a camera (22) is guided in an adjustable manner along the pin (1) in order to magnify the contact region (4) of the probe pin (1) and the test environment surrounding the contact region (4) of the probe pin (1).

## Revendications

1. Sonde ou tête de mesure pour mesurer un signal électrique d'un contact électrique comportant un palpeur électriquement conducteur (1) faisant saillie d'un boîtier (3), à l'extrémité duquel est prévue une zone de contact (4) pouvant être mise en contact du contact électrique,
dans laquelle la zone de contact (4) du palpeur (1) et l'environnement entourant la zone de contact (4) du palpeur (1) sont éclairés par une source lumineuse (10₁, 10₂,..., 10ₙ, 10ₒ) en relation avec la sonde ou la tête de mesure,
**caractérisée en ce que**
la couleur des rayons lumineux générés par la source lumineuse désigne le canal de mesure (6) utilisé par la sonde ou la tête de mesure dans l'appareil de mesure (7).

2. Sonde ou tête de mesure selon la revendication 1, **caractérisée en ce que**
l'éclairage de la zone de contact (4) et du champ de mesure entourant la zone de contact (4) du palpeur (1) est généré par les rayons lumineux d'une source lumineuse (10₁, 10₂,..., 10ₙ) disposée à proximité de la zone de contact (4) dans le palpeur (1).

3. Sonde ou tête de mesure selon la revendication 1, **caractérisée en ce que**
l'éclairage de la zone de contact (4) du palpeur (1) et du champ de mesure entourant la zone de contact (4) du palpeur (1) est généré par des rayons lumineux d'une source lumineuse (10₁, 10₂,..., 10ₙ), qui se trouve dans le boîtier (3) de la sonde ou de la tête de mesure, dans un appareil de mesure (7) relié à la sonde ou à la tête de mesure ou dans un autre module (19) en relation avec la sonde ou la tête de mesure.

4. Sonde ou tête de mesure selon la revendication 3, **caractérisée en ce que**
les rayons lumineux de la source lumineuse (10₁, 10₂,..., 10ₙ), qui se trouve dans le boîtier (3) de la sonde ou de la tête de mesure, dans l'appareil de mesure (7) relié à la sonde ou à la tête de mesure ou dans un module supplémentaire (19) en relation avec la sonde ou la tête de mesure, sont guidés par l'intermédiaire d'une couche isolante (9) entourant le palpeur (1) à l'exception de la zone de contact (4) vers la zone de contact (4) du palpeur (1) et vers le champ de mesure entourant la zone de contact (4) du palpeur (1).

5. Sonde ou tête de mesure selon la revendication 3, **caractérisée en ce que**
les rayons lumineux de la source lumineuse (10₁, 10₂, ..., 10ₙ), qui se trouve dans le boîtier (3) de la sonde ou de la tête de mesure, dans l'appareil de mesure (7) relié à la sonde ou à la tête de mesure ou dans un module supplémentaire (19) en relation avec la sonde ou la tête de mesure, sont guidés par au moins un évidement (15₁, 15₂,... 15ₙ, 15ₘ) dans le boîtier (3) vers la zone de contact (4) du palpeur (1) et vers le champ de mesure entourant la zone de contact (4) du palpeur (1).

6. Sonde ou tête de mesure selon la revendication 4 ou 5, **caractérisée en ce que**
un faisceau de rayons lumineux est généré par formation ciblée de la couche isolante (9) et par formation ciblée et positionnement des évidements (15₁, 15₂,..., 15ₙ, 15ₘ) dans le boîtier (3).

7. Sonde ou tête de mesure selon l'une des revendications 4 à 6, **caractérisée en ce que**
une couche de diffusion de lumière (18) est disposée pour obtenir un faisceau lumineux diffus à l'extrémité de la couche isolante (9) associée à la zone de contact (4) et/ou dans les évidements (15₁, 15₂,..., 15ₙ, 15ₘ) dans le boîtier (3).

8. Sonde ou tête de mesure selon l'une des revendications 1 à 7, **caractérisée en ce que**
une lentille optique (21) ou une caméra (22) est guidée pouvant être ajustée le long du palpeur (1) pour grossir la zone de contact (4) du palpeur (1) et du champ de mesure entourant la zone de contact (4) du palpeur (1).
